(19) **Europäisches Patentamt**
**European Patent Office**
**Office européen des brevets**

(11) **EP 2 174 415 B1**

(12) **FASCICULE DE BREVET EUROPEEN**

(45) Date de publication et mention
de la délivrance du brevet:
**05.12.2012 Bulletin 2012/49**

(51) Int Cl.:
***H03H 7/48*** (2006.01)

(21) Numéro de dépôt: **08775157.4**

(86) Numéro de dépôt international:
**PCT/EP2008/059338**

(22) Date de dépôt: **16.07.2008**

(87) Numéro de publication internationale:
**WO 2009/016036 (05.02.2009 Gazette 2009/06)**

(54) **COUPLEUR DE PUISSANCE POUR GENERATEUR HAUTE FREQUENCE INDUSTRIELLE**

LEISTUNGSKOPPLER FÜR EINEN INDUSTRIELLEN HOCHFREQUENZGENERATOR

POWER COUPLER FOR INDUSTRIAL HIGH FREQUENCY GENERATOR

(84) Etats contractants désignés:
**AT BE BG CH CY CZ DE DK EE ES FI FR GB GR
HR HU IE IS IT LI LT LU LV MC MT NL NO PL PT
RO SE SI SK TR**

(30) Priorité: **02.08.2007 FR 0705669**

(43) Date de publication de la demande:
**14.04.2010 Bulletin 2010/15**

(73) Titulaire: **THALES
92200 Neuilly-sur-Seine (FR)**

(72) Inventeur: **DARGES, Bernard
F-95320 Saint Leu La Forêt (FR)**

(74) Mandataire: **Lucas, Laurent Jacques
Marks & Clerk France
Conseils en Propriété Industrielle
Immeuble Visium
22, Avenue Aristide Briand
94117 Arcueil Cedex (FR)**

(56) Documents cités:
**WO-A-03/077414     JP-A- 2 189 886
US-A- 3 480 881**

**Description**

L'invention concerne un dispositif de couplage pour générateurs haute fréquence industrielle (d'acronyme HFI) état solide. Ces générateurs peuvent être utilisés notamment dans des dispositifs de chauffage par induction électromagnétique, par pertes diélectriques ou par plasma.

Le chauffage par induction électromagnétique consiste à produire l'échauffement d'une pièce conductrice par la circulation de courants induits par un champ magnétique. Ce moyen permet de chauffer la pièce dans sa masse sans contact direct avec la source d'énergie. La pièce à chauffer (ou induit) est entourée d'au moins une boucle de circulation de courant (ou inducteur).

Les fréquences de travail du générateur sont comprises entre quelques dizaines de kilohertz et quelques mégahertz. Les puissances nécessaires varient entre quelques kilowatts à plus d'un mégawatt. Le chauffage par induction électromagnétique est utilisé largement dans l'industrie et dans le domaine scientifique. Dans l'industrie, il est utilisé notamment en métallurgie pour affiner des métaux, pour traiter thermiquement des pièces métalliques ou pour produire des tubes soudés en continu.

Le chauffage par pertes diélectriques consiste à produire l'échauffement d'une pièce isolante en provoquant des pertes dans sa masse, à partir d'un champ électrique alternatif. La pièce à chauffer est un isolant médiocre. Elle est placée entre deux armatures conductrices alimentées par une source alternative. On crée un condensateur dont le diélectrique est la pièce à chauffer. Les générateurs utilisés ont généralement des fréquences de travail plus élevées que celles des générateurs de chauffage par induction électromagnétique. Elles peuvent être comprises entre quelques dizaines de mégahertz et quelques gigahertz. Ce mode de chauffage s'utilise dans l'industrie du bois pour le séchage ou le collage, dans l'industrie textile ou dans la fabrication ou le façonnage de matières plastiques.

Le chauffage par plasma consiste à ioniser un milieu gazeux pour le transformer en plasma. L'énergie cinétique des électrons se transforme en chaleur. Il se produit une élévation considérable de température. La pièce à chauffer est placée dans le plasma. La transformation du milieu gazeux en plasma est obtenue par l'émission d'une antenne. Les fréquences de travail du générateur sont comprises entre 1 mégahertz et quelques dizaines de mégahertz. Le mode de chauffage est utilisé dans de nombreuses applications industrielles telle que la fusion de produits réfractaires, la synthèse chimique etc...

Des étages de puissances à tubes sont utilisés pour fournir les puissances importantes nécessaires au chauffage industriel, mais les progrès réalisés dans le domaine des transistors de puissance conduisent progressivement au remplacement des tubes par des étages de puissance à état solide d'utilisation plus souple.

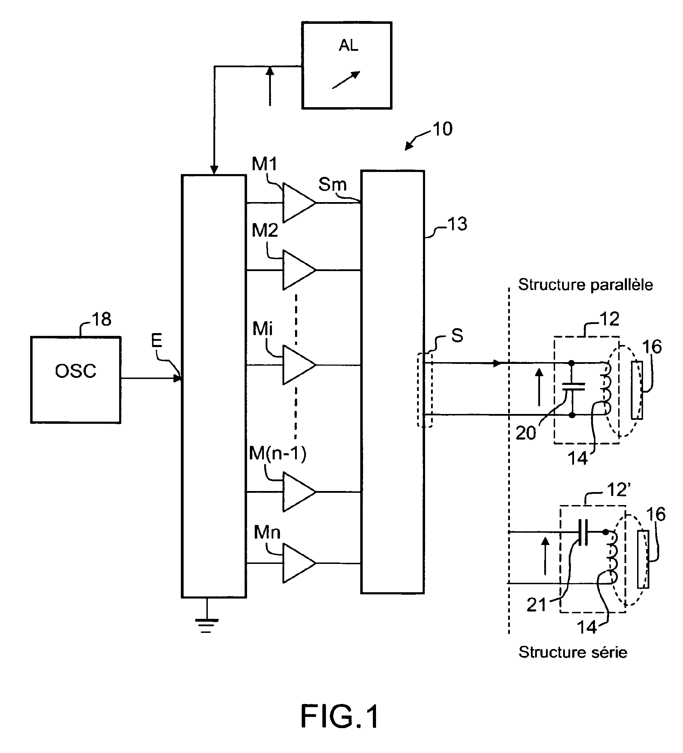

La figure 1 représente un schéma de principe d'un générateur haute fréquence industrielle de l'état de l'art comportant un amplificateur haute fréquence 10 de puissance état solide connecté, par sa sortie S de puissance, à un circuit résonnant 12,12' (charge de l'amplificateur).

L'étage de puissance 10 connecté au circuit résonnant 12, 12' comporte une pluralité de moules M1, M2, ....Mi,...Mn à transistors couplés en sortie des modulés par un système de couplage 13 pour fournir la puissance haute fréquence nécessaire.

Le circuit résonnant, de structure parallèle 12, ou de structure série 12', comporte un inducteur 14 pour le chauffage d'une pièce 16. Un oscillateur 18 (OSC) fournit un signal haute fréquence, de fréquence f, à une entrée E de l'amplificateur de puissance 10.

Dans l'exemple de la figure 1, le chauffage de la pièce 16 est réalisé par induction. L'inducteur 14 est une bobine 14 couplée à la pièce 16. Une capacité 20,21 d'accord en parallèle, ou série, selon la structure, avec la bobine 14 réalise le circuit résonnant 12, 12' à la fréquence d'induction.

Pour obtenir des puissances HF importantes (de quelques kW à plusieurs MW), la sommation de modules élémentaires M1, M2, ....Mi,...Mn RF à transistors, fournissant chacun une partie de la puissance totale en sortie du générateur de chauffage, devient la seule solution dans les émetteurs état solide.

Ces modules élémentaires à transistors sont des générateurs de tension et mettre des générateurs de tension en parallèle pose des problèmes de couplage importants. En effet, les générateurs de tensions doivent être couplés en série (principe de Thèvenin), les générateurs de courant doivent être couplés en parallèle (principe de Norton). Le moindre décalage en tension ou en phase des générateurs de tension couplés en parallèle générerait instantanément des courants très importants dans les modules élémentaires du à leur faible impédance ce qui causerait immédiatement leur destruction.

Le couplage en parallèle des modules élémentaires, générateurs de tension, est encore plus difficile à réaliser du fait qu'il fournissent des signaux carrés. En effet les transistors des modules fonctionnent dans un régime bloqué/ saturé afin d'améliorer leur rendement.

Pour éviter ce problème de couplage en parallèle du fait des dispersions des tensions en sortie des modules élémentaires, il existe des solutions connues.

La première solution est un couplage en parallèle par coupleur à ligne 3dB. Celui comporte une résistance de charge référencée à la masse. Lors d'un déséquilibre d'une voie par rapport à l'autre (en phase ou (et) en amplitude), la différence sera absorbée par cette charge dite «charge poubelle ». Mais la taille de ce type de coupleur, en λ/4 est trop importante compte tenu des fréquences de fonctionnement relativement basses des émetteurs HFI.

La deuxième solution est le coupleur dit de « Wilkinson » Celui comporte une résistance de charge flottante. Lors d'un déséquilibre d'une voie par rapport à l'autre (en phase ou/et en amplitude), la différence sera absorbée par cette charge flottante.

Ces deux types de coupleurs cité précédemment sont très utilisés dans le domaine de la RF pour des fréquences supérieures à 30MHz.

La troisième solution est le coupleur à ferrite équipé d'une charge de déséquilibre (ou charge poubelle) qui est un hybride du coupleur de Wilkinson. Ce type de coupleur est utilisé dans le domaine de la RF pour des fréquences supérieures à 2 MHz.

La quatrième solution est un coupleur en pont de Winston. Celui-ci est équipé d'une charge de déséquilibre. Lors d'un déséquilibre d'une voie par rapport à l'autre (en phase ou/et en amplitude), la différence sera absorbée par cette charge de déséquilibre. Ce type de coupleur est utilisé dans le domaine de la RF pour des fréquences inférieures à 2 MHz, par exemple, pour coupler les émetteurs Ondes Longues et Ondes Moyenne forte puissance (100kW à 1 MW).

Mais ces types de coupleurs cités, outre les problèmes de coût et de réalisation, dissipent de l'énergie en pure perte dans les charges de déséquilibre ou charges poubelles, dissipation d'énergie liée aux écarts de tension de sortie entre les modules élémentaires couplés. Cette dissipation d'énergie conduit à une baisse du rendement du générateur de chauffage.

A fin de pallier les inconvénients des dispositifs de couplage de modules élémentaires des émetteurs HFI, l'invention propose un dispositif de couplage d'amplificateurs élémentaires haute fréquence fonctionnant à une fréquence f, comportant n entrées haute fréquence E1, E2, ...Ei...Ep...En, n étant un nombre entier supérieur à 1, i et p étant deux nombres entiers compris entre 1 et n, p étant différent de i, et une sortie haute fréquence de puissance pour fournir à une charge une puissance somme des puissances fournies par l'ensemble des amplificateurs élémentaires connectés par leurs sorties de puissance auxdites entrées haute fréquence,

caractérisé en ce qu'il comporte n selfs L1, L2, Li,...Lp,...Ln connectées par une de leurs extrémités à une respective entrée haute fréquence E1, E2, ...Ei,...Ep,...En, leurs autres extrémités étant connectées ensemble à une extrémité d'une capacité de sortie dont l'autre extrémité est connectée à la sortie haute fréquence pour former autant de circuits résonants LC série, résonnant à la fréquence de fonctionnement f, entre les entrées E1, E2, ...Ei,...Ep,...En et la sortie haute fréquence, que d'amplificateurs à coupler.

Un principal but du dispositif de couplage selon l'invention est coupler sans pertes des modules élémentaires à transistors malgré une dispersion des tensions de sortie des modules élémentaires, tout en assurant leur sécurité.

Un autre but est de diminuer le coût du dispositif de couplage.

L'invention concerne aussi un générateur haute fréquence industrielle (HFI) comportant une pluralité de modules élémentaires (M1, M2,...Mn) état solide haute fréquence, caractérisé en ce que les modules élémentaires sont couplés par leurs sorties de puissance par un dispositif de couplage selon l'invention.

L'invention sera mieux comprise à l'aide d'exemples de réalisation en références aux figures indexées dans lesquelles :

- la figure 1, déjà décrite, représente un schéma de principe d'un générateur haute fréquence industrielle de l'état de l'art ;
- la figure 2a montre un synoptique de principe d'un coupleur à deux voies selon l'invention ;
- la figure 2b représente le coupleur de la figure 2a sous forme de quadripôle ;
- la figure 2c représente une structure du coupleur à n voies selon l'invention représentée sous forme de quadripôle
- la figure 3a montre une première partie du quadripôle à deux entrées de la figure 2b ;
- la figure 3b montre le quadripôle de la figure 3a comportant des selfs ;
- la figure 4a montre une autre partie du quadripôle de la figure 2b ;
- la figure 4b montre le quadripôle de la figure 4a comportant une self de valeur L en série avec une capacité de valeur C ;
- la figure 4c montre le quadripôle de la figure 4a comportant une self de valeur L en série avec la capacité de valeur C ;
- la figure 5 montre un coupleur selon l'invention résultant de ladite superposition des parties de coupleur des figures 4b et 4c ;
- la figure 6 montre un coupleur à n entrées selon l'invention ;
- la figure 7a montre un coupleur à deux voies selon l'invention ;
- la figure 7b montre la configuration de fonctionnement normal du coupleur de la figure 7a avec des tensions d'entrée identiques ;
- la figure 7c montre, une configuration de fonctionnement du coupleur avec des tensions d'entrée différentes ;
- la figure 8a montre le coupleur de la figure 7a avec un générateur en court circuit ;
- la figure 8b montre, la forme et l'amplitude des tensions et courants dans le coupleur de la figure 8a ;

- la figure 9a montre le coupleur de la figure 7a avec un générateur en court ouvert ;
- la figure 9b montre, la forme et l'amplitude des tensions et courants dans le coupleur de la figure 9a.
- la figure 10 montre une réalisation d'adaptation du coupleur, selon l'invention, chargé par l'inducteur d'un émetteur HFI.

Le coupleur selon l'invention décrit par la suite satisfait aux objectifs suivants :

- coupler plusieurs modules élémentaires à transistors pour réaliser l'étage de puissance du générateur HFI. Ces modules élémentairs état solide sont des générateurs de tension qui fournissent des signaux de forme rectangulaire (de période T=1/f) ce qui constitue une difficulté pour le couplage,
- réaliser un dispositif de couplage à faible coût.

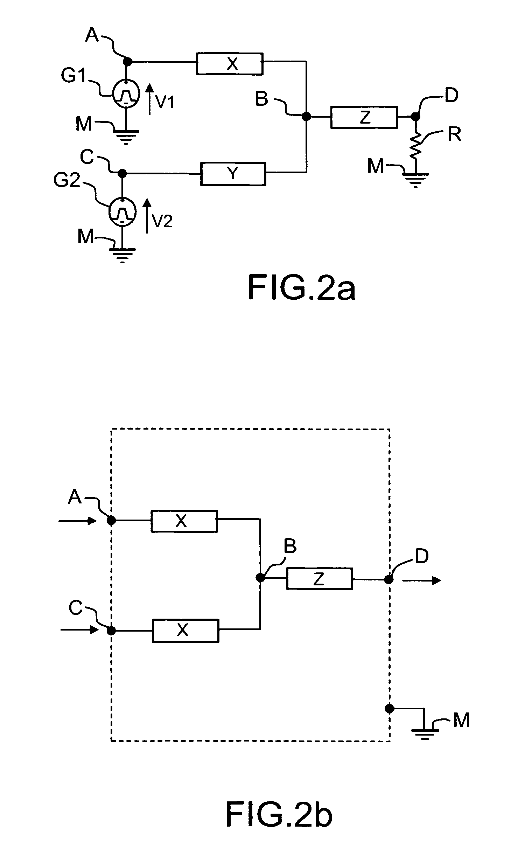

La figure 2a montre un synoptique de principe d'un coupleur à deux voies selon l'invention. La figure 2b représente aussi le coupleur de la figure 2a sous forme de quadripôle.

Le coupleur de la figure 2a comporte une entrée A d'une première voie, une entrée C de la deuxième voie et une sortie D du coupleur. L'entrée A du coupleur est destinée à recevoir un premier générateur G1 de tension V1, l'entrée C un deuxième générateur G2 de tension V2 et la sortie D une charge R.

Une impédance X est connectée par une de ses extrémités sur l'entrée A de la première voie, une impédance Y est connectée par une de ses extrémités sur l'entré C de la deuxième voie et une impédance de sortie Z est connectée entre un point de connexion B entre les deux extrémités libres des impédances X et Y et la sortie D du coupleur.

Les conditions suivantes dans le coupleur de la figure 2a doivent être respectées :

- une très grande impédance entre les entrées A et C pour créer au moins une isolation de -20dB entre les générateurs de tension G1, G2 connectés aux entrées A et C du coupleur,
- une impédance vue par le premier générateur G1 connecté à l'entrée A de la première voie égale à la charge R,
- une impédance vue par le deuxième générateur G2 appliqué à l'entrée C de la deuxième voie égale à la charge R,
- afin d'effectuer une sommation de tensions V1, V2 des deux générateurs G1 et G2 dans les meilleures conditions, la tension en sortie des impédances X et Y connectées au point de connexion B doit être sinusoïdale,
- en outre, pour une sommation des tensions V1, V2 des générateurs G1, G2, le quadripôle représenté à la figure 2b devra être symétrique et réciproque, ce qui conduit à ce que l'impédance X de la première voie soit égale à l'impédance Y de la deuxième voie.

La structure résultante satisfaisant à ces conditions est représentée à la figure 2b. Les deux impédances connectées aux deux entrées A et C sont identiques par exemple égales à une impédance X.

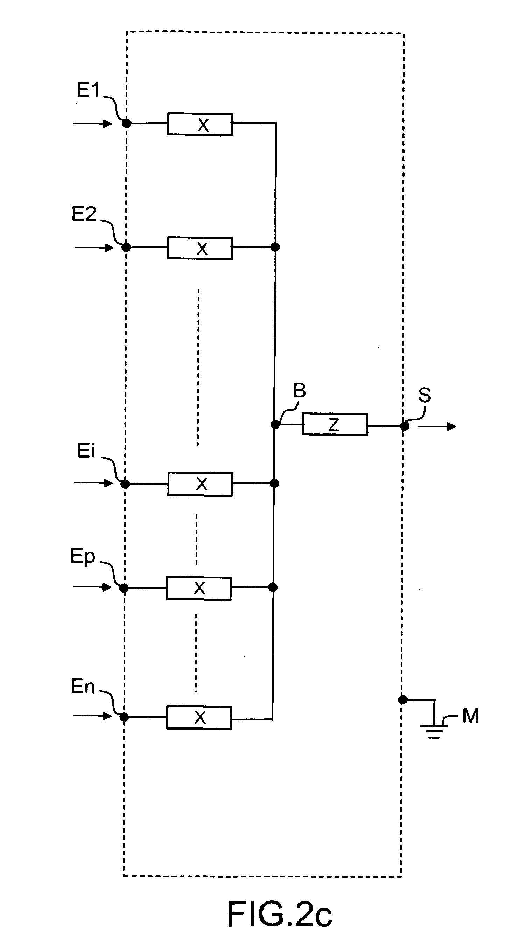

La figure 2c représente une structure du coupleur à n voies selon l'invention représentée sous forme de quadripôle, satisfaisant auxdites conditions. La structure de la figure 2c comporte n entrées E1, E2, ...Ei,...Ep,...En et une sortie S, n étant un nombre entier supérieur à 1, i et p étant deux nombres entiers compris entre 1 et n, p étant différent de i.

Le coupleur de la figure 2c comporte n impédances X dont une des extrémités est connectée à une respective entrée Ei du coupleur, les autres extrémités libres des impédances X étant connectées au point de connexion B, l'impédance de sortie Z est connectée entre le point de connexion B et la sortie S du coupleur.

Il s'agit de trouver, pour une telle configuration représentée à la figure 2c, une impédance X créant une impédance élevée entre deux entrées Ei, Ep, quelconques du coupleur afin de créer une isolation importante entre lesdites entrées. Un élément selfique permet d'assurer cette condition d'isolement.

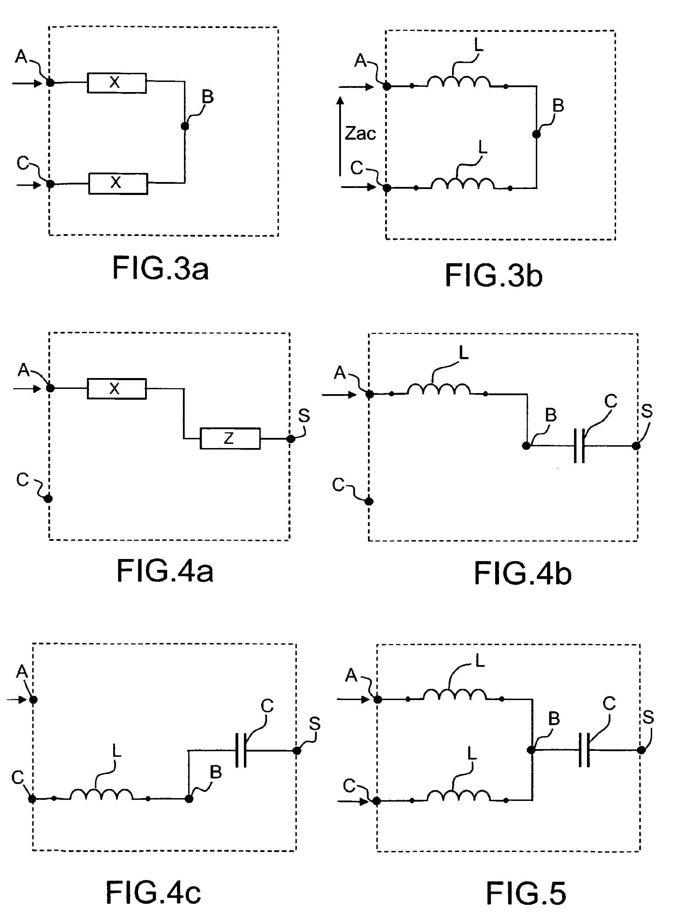

La figure 3a montre une première partie du quadripôle à deux entrées de la figure 2b comportant les deux impédances X connectées par une de leurs extrémités respectivement à l'une A et l'autre entrée C et par leurs extrémités libres au point de connexion B.

La figure 3b montre le quadripôle de la figure 3a comportant des selfs. Les impédances X du quadripôle de la figure 3a sont des selfs de valeur L pour réaliser la condition d'isolement entre les deux entrés A et C du quadripôle. L'impédance Zac entre les deux entrées A et C est alors exprimée par :

$$Zac = (L+ L).2.\pi.f$$

f étant la fréquence de fonctionnement des générateurs G1, G2 appliqués aux entrés A et B du quadripôle.

Mais comme cela a été dit précédemment, d'autres critères doivent aussi être assurés par le coupleur selon l'invention :

- l'impédance vue par une des entrés quelconque du quadripôle Ei (voir figure 2c) doit être égale à la charge R,
- l'impédance du circuit entre l'entrée Ei considérée du coupleur et la sortie S (ou point D) du coupleur devra être un court circuit (ou de valeur d'impédance très faible) de façon à limiter les pertes de transmission entre l'entrée Ei considérée et la sortie S du coupleur,
- la tension au point de connexion B entre l'impédance X connectée à l'entrée Ei considérée et l'impédance Z connectée à la sortie S du coupleur doit être sinusoïdale.

Un circuit résonnant série de type LC peut réaliser ces conditions. L'impédance de sortie Z sera par conséquent une capacité de valeur C formant avec la self de valeur L connectée à l'entrée considérée Ei, un circuit résonnant série à la fréquence f de fonctionnement des générateurs.

Pour illustrer ces considérations :

- la figure 4a montre une autre partie du quadripôle de la figure 2b avec l'impédance X connectée à une des entrées A et l'impédance de sortie Z en série connectée à la sortie S.
- la figure 4b montre le quadripôle de la figure 4a comportant une self de valeur L en série avec une capacité de valeur C formant un circuit résonnant LC série entre l'entré A et la sortie S du quadripôle.
- la figure 4c montre le quadripôle de la figure 4a comportant une self de valeur L en série avec la capacité de valeur C formant un autre circuit résonnant LC série entre l'autre entrée C et la sortie S du quadripôle.

En appliquant le théorème de superposition, la structure du coupleur à deux entrées A et C peut être établie.

La figure 5 montre un coupleur selon l'invention résultant de ladite superposition des parties de coupleur des figures 4b et 4c comportant deux selfs et une capacité de sortie de valeur C. Chaque self est respectivement connectée par une de ses extrémités à chacune des deux entrées A et C du coupleur et par leur autre extrémité au point de connexion B et à une des extrémités de la capacité de sortie de valeur C connectée par son autre extrémité à la sortie S du coupleur.

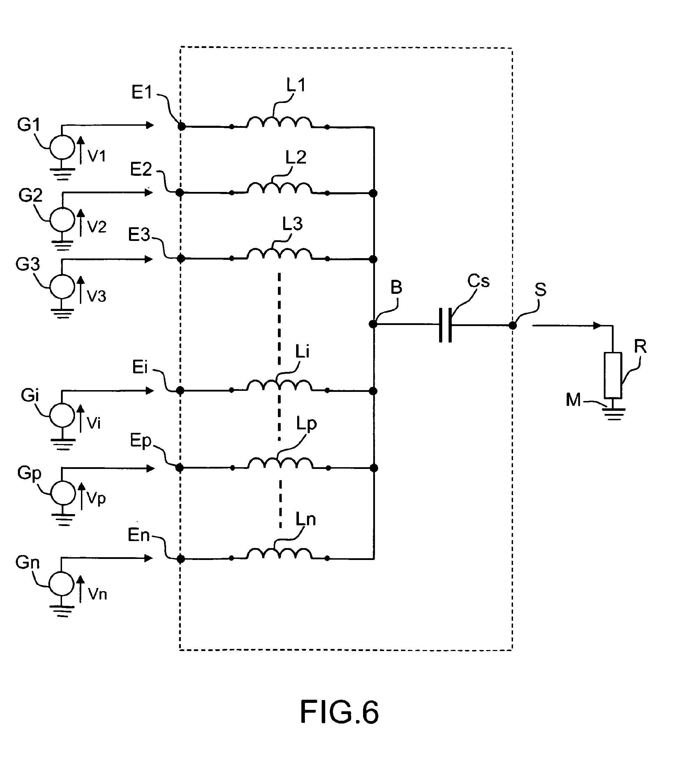

La figure 6 montre un coupleur à n entrées selon l'invention satisfaisant aux conditions explicitées précédemment.

Le coupleur de la figure 6 comporte n entrées E1, E2,...Ei,...Ep....En, n étant un nombre entier supérieur à 1, i et p étant deux nombres entiers compris entre 1 et n, p étant différent de i, et une sortie S de puissance fournie par l'ensemble de générateurs, aux pertes près du coupleur.

Chacune des entrées du coupleur est destinée à être connectée à un respectif générateur de tension G1, G2,...Gi,...Gp,....Gn, fournissant des respectives tensions V1, V2, ...Vi,...Vp,..Vn. La sortie S du coupleur est destinée à être connectée à une charge R de puissance. Dans le cas d'un émetteur HFI état solide, les générateurs sont des modules élémentaires à transistors, la charge est le circuit résonnant comportant la pièce à chauffer.

Le coupleur de la figure 6 à n entrées comporte n selfs L1, L2, Li,...Lp...Ln chacune des selfs étant connectée par une de ses extrémités à une respective entrée E1, E2, ...Ei,...Ep,...En du coupleur et par son autre extrémité libre à un point commun B de connexion avec une extrémité d'une capacité de sortie Cs connectée par son autre extrémité à la sortie S du coupleur.

Dans une réalisation prefférentielle les valeurs des selfs L1, L2, Li,...Ln sont identiques, soit de valeur L, la capacité de sortie Cs est de valeur C.

Détermination des impédances $Z_{Ei,Ep}$ entre deux entrées Ei et Ep du coupleur :

A) Premier cas d'un coupleur à deux entrées E1, E2 (n=2) :

La fréquence de résonance f, qui est aussi la fréquence de fonctionnement des générateurs (ou des amplificateurs élémentaires de la figure 1), vue par une des deux entrées E, E2 du coupleur est :

$$f = \frac{1}{2 \cdot \pi \sqrt{L \cdot \dfrac{C}{2}}} \quad (1)$$

L étant la valeur identique des selfs L1, L2, et C la valeur de la capacité de sortie Cs.

Le module de l'impédance $Z_{E1,E2}$ entre les deux entrées E1 et E2 du coupleur sera donné par :

$$|Z_{E1,E2}| = (L+L).2.\pi.f = 4.L.\pi.f$$

B) Deuxième cas d'un coupleur à n entrées E1, E2, ...Ei,...Ep,....En : La fréquence de résonance f, qui est aussi la fréquence de fonctionnement des générateurs, vue par une des entrées Ei du coupleur est

$$f = \frac{1}{2 \cdot \pi \sqrt{L \cdot \dfrac{C}{n}}}$$

L étant la valeur identique des selfs L1, L2, Li,...Lp,...Ln et C la valeur de la capacité de sortie Cs du coupleur.
Le module de l'impédance $Z_{Ei,Ep}$ entre les deux entrées Ei et Ep différentes du coupleur sera donné par :

$$|Z_{Ei,Ep}| = (L+(L/n-1)).2.\pi.f$$

En pratique l'impédance $Z_{Ei,Ep}$ entre deux entrées du coupleur sera au moins d'un facteur $K_n$ supérieur à la valeur de la charge R appliquée à la sortie S du coupleur. Par exemple ce facteur $K_n$ peut être égal à 20.
Par exemple dans le cas d'un coupleur à deux entrées E1, E2, d'une charge R de valeur égale à 10 Ohm et une fréquence de fonctionnement f = 500KHz

$$|Z_{E1,E2}|/R > K_2,$$

$K_2$ étant un facteur exprimant le rapport entre l'impédance $Z_{E1,E2}$ entre les deux entrés E1 et E2 du coupleur à deux voies et la valeur R de la charge du coupleur,
ou exprimé en fonction de L et f :

$$4.L.\pi.f/R > K_2$$

la valeur L de chacune des selfs L1, L2 sera supérieure à une valeur minimum de L telle que

$$L > K_2.R/4.L.\pi.f$$

Si $K_2$=20 cela donne la valeur de L, soit

$$4.L.\pi.f/R > 20, \quad soit \quad L > 5.R/\pi.f$$

soit, en utilisant les valeurs numériques de R et f
la valeur L des selfs L1, L2 est
L=31,8$\mu$H
La valeur C de la capacité de sortie Cs sera alors, calculée à partir de l'expression (1) :

$$C = \frac{1}{f^2 . 2 . \pi^2 . L}$$

soit C=6,38nF

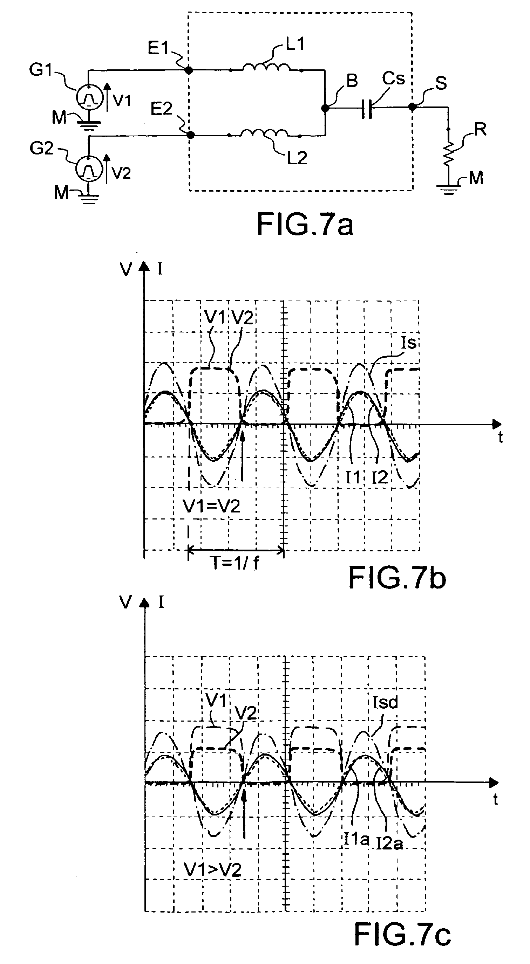

A titre d'exemple, la figure 7a montre un coupleur à deux voies selon l'invention comportant une première entrée E1, une seconde entrée E2 et une sortie de couplage S. Le coupleur comporte deux selfs L1 et L2 et une capacité de sortie Cs.

Les valeurs L des selfs L1 et L2 et la valeur C de la capacité de sortie Cs du coupleur de la figure 7a sont déterminées comme cela a été décrit précédemment, en fonction de la fréquence de fonctionnement f des générateurs et de la valeur de la charge R appliquée à la sortie S du coupleur.

La première entrée E1 du coupleur est attaquée par un générateur G1 de tension V1, la deuxième entrée E2 est attaque par un générateur G2 de tension V2.

Dans une première configuration de fonctionnement normal les tensions des deux générateurs sont identiques, V1=V2.

La figure 7b montre la configuration de fonctionnement normal du coupleur avec des tensions d'entrée identiques. Les courbes en pointillé montrent la forme et l'amplitude des tensions V1, V2 et les courbes en trait plein (confondues sur la figure), les courants I1, I2 fournis par les deux générateurs.

Les tensions V1 et V2 sont de forme rectangulaire et de période T=1/f.

Les courants I1, I2 fournis par les générateurs sont identiques I1=I2 et le courant Is en sortie S du coupleur est égal à la somme des courants I1+I2 fournis par les deux générateurs.

Dans cette première configuration, le passage du courant par 0ampères s'effectue lors du passage des tensions V1, V2 par 0volts.

Dans une deuxième configuration de fonctionnement, la tension V2 du générateur G2 est inférieure à la tension V1 du générateur G1 V2<V1 (par exemple de 40%).

La figure 7c montre, une configuration de fonctionnement du coupleur avec des tensions d'entrée différentes. Les courbes en pointillé montrent la forme et l'amplitude des tensions V1, V2, et les courbes en trait plein, les courants I1a, I2a fournis par les deux générateurs.

La courbe V1 (en pointillé) montre la tension du premier générateur G1 et la courbe V2 (en pointillé) celle du deuxième générateur G2.

Malgré la différence des tensions, les deux générateurs délivrent des courants identiques I1a=I2a, inférieurs aux courants I1 et I2 de la première configuration du fait d'une tension V2 inférieure à la tension V1. Le courant Isa en sortie du coupleur est la somme des deux courants I1a+I2a fournis par les générateurs. Par ailleurs l'accord du coupleur n'est pas changé et les courants et les tensions passant en même temps par une valeur nulle.

Dans une troisième configuration de fonctionnement, le deuxième générateur G2 est en court circuit. La tension V2 est égale à 0 volt et la deuxième entrée E2 du coupleur se trouve au potentiel de référence du deuxième générateur G2, soit la masse M.

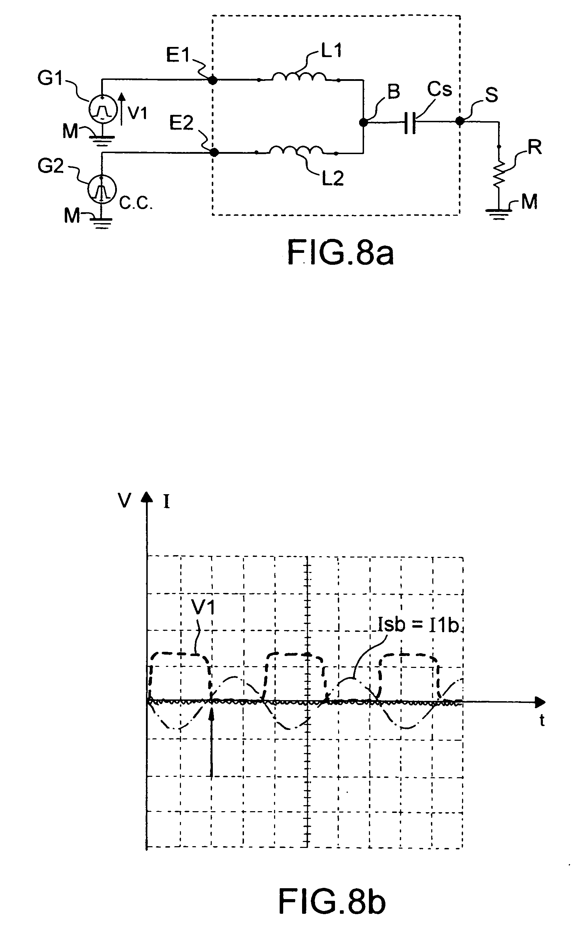

La figure 8a montre le coupleur de la figure 7a avec un générateur en court circuit.

La figure 8b montre, la forme et l'amplitude des tensions et courants dans le coupleur de la figure 8a.

La sortie du premier générateur G1 se trouve, dans cette troisième configuration, connecté à la masse M par la première L1 et la deuxième selfL2 en série. Le coupleur se comporte comme un transformateur vis-à-vis du premier générateur. Selon le principe utilisé pour la réalisation de ce coupleur selon l'invention, l'isolement entré les deux entrés est important (au moins de -20dB). Le générateur G1 fournit un courant I1b dans la charge R sans être perturbé par le court circuit sur la seconde entrée E2.

La courbe V1 montre la tension rectangulaire du premier générateur et la courbe I1b le courant. Le passage du courant I1b par 0 ampère s'effectue toujours par le passage par 0volt de V1.

Dans une quatrième configuration de fonctionnement, le deuxième générateur G2 est en circuit ouvert. Dans cette quatrième configuration la tension V2 aux bornes de la deuxième entrée du coupleur est égale à 0 volt avec une impédance par rapport au potentiel de référence (par exemple la masse M) infinie (entrée E2 en l'air).

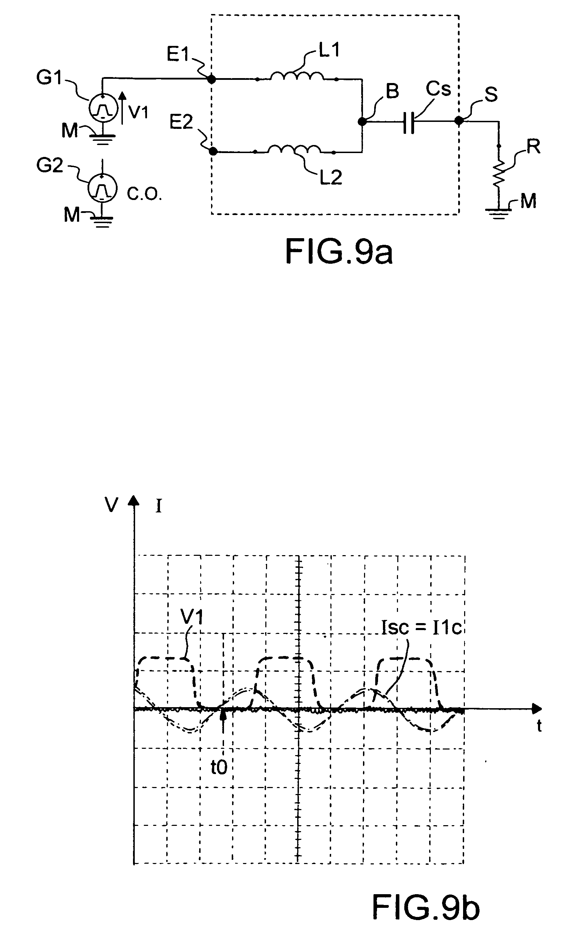

La figure 9a montre le coupleur de la figure 7a avec un générateur en circuit ouvert.

La figure 9b montre, la forme et l'amplitude des tensions et courants dans le coupleur de la figure 9a.

Le coupleur se comporte vis à vis du premier générateur G1 comme une simple cellule self/capacité série (LC). Le circuit LC est désaccordé par rapport à la fréquence de fonctionnement f du générateur mais ne présente pas de danger pour le générateur équipé de transistors de commutation. Seul un régime capacitif est dangereux pour les étages à transistors. Le passage d'un courant I1c par 0 ampère ne s'effectue plus pour une tension V1 passant par 0volt du au régime selfique produit par le désaccord du circuit (repère t0 sur la figure 9b)

Nous avons décrit un coupleur (ou dispositif de couplage) connecté par sa sortie sur une charge R d'impédance résistive, mais dans le cas d'utilisation, par exemple, dans un émetteur HFI le coupleur est destiné à alimenter par sa sortie de puissance S un circuit résonnant, de structure parallèle 12, ou de structure série 12', (voir figure 1) comportant un inducteur 14 pour le chauffage d'une pièce 16. Dans cette configuration d'utilisation, le coupleur de puissance sert aussi d'adaptateur de l'inducteur 16 à une fréquence de résonance qui est la fréquence de fonctionnement de l'émetteur.

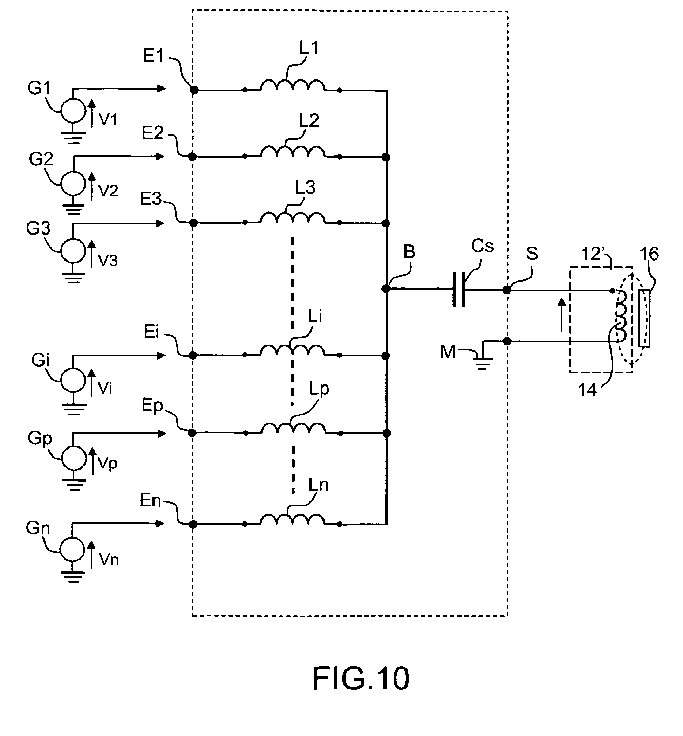

La figure 10 montre une réalisation d'adaptation du coupleur, selon l'invention, chargé par l'inducteur 14 d'un émetteur HFI.

Dans l'application de la figure 10, la charge R est un inducteur 14 de chauffage d'une pièce 16. La valeur Csr de la capacité de sortie Cs du coupleur est calculée pour obtenir l'accord avec l'inducteur 14 ainsi que l'accord de chacune des voies d'entrées E1, E2,...Ei,...Ep....En du coupleur à une fréquence de résonance égale à la fréquence de fonctionnement f du coupleur.

Cette réalisation d'adaptation de la figure 10 comporte l'avantage de réduire le coût de l'émetteur HFI, la capacité de sortie Cs du coupleur étant aussi la capacité d'accord de l'inducteur 14 à la fréquence de résonance f.

L'invention concerne aussi un générateur haute fréquence industrielle (HFI) état solide tel que représente à la figure 1 comportant un coupleur 13 selon l'invention.

La charge du générateur de chauffage est un circuit résonant 12 couplé électromagnétiquement à la pièce à chauffer 16 et équivalent soit à un circuit R, L, C parallèle, soit à un circuit R, L, C série. Le coefficient de surtension Q du circuit résonant 12 est élevé et le désaccord est facile au voisinage de la fréquence de résonance.

L'impédance de charge du générateur de chauffage est essentiellement variable car elle dépend des caractéristiques des éléments constituant le circuit résonant et notamment du matériau de la pièce à chauffer, de leurs dimensions et de leur position relative. Cette position est importante surtout si la pièce à chauffer est en mouvement, par exemple si c'est une plaque de tôle chauffée par induction que l'on roule et que l'on soude en continu.

La fiabilité des modules à transistors est liée à la charge ramenée sur les transistors des modules. Une impédance dite réactive produisant un taux d'onde stationnaire (TOS) important provoque la destruction des transistors.

Dans les générateurs état solide, l'optimisation du rendement, la fiabilité avoisinant le 100% pour les modules à transistors des étages de puissance haute fréquence, constituent les critères clé et essentiels pour l'utilisateur.

Une solution par l'asservissement de la fréquence de l'oscillateur OSC du générateur haute fréquence attaquant l'étage de puissance 10 peut être mise en place. Un asservissement de la fréquence f du générateur de chauffage comporte l'avantage de protéger le transistor et d'éviter de passer accidentellement dans un régime capacitif pour les transistors.

**Revendications**

1. Dispositif de couplage d'amplificateurs élémentaires haute fréquence (M1, M2,...Mn) fonctionnant à une fréquence f, comportant n entrées haute fréquence E1, E2, ...Ei,...Ep,...En, n étant un nombre entier supérieur à 1, i et p étant deux nombres entiers compris entre 1 et n, p étant différent de i, et une sortie (S) haute fréquence de puissance pour fournir à une charge (R) une puissance somme des puissances fournies par l'ensemble des amplificateurs élémentaires connectés par leurs sorties de puissance (sm) auxdites entrées haute fréquence, **caractérisé en ce qu'**il comporte n selfs L1, L2, Li,...Lp,...Ln connectées par une de leurs extrémités à une respective entrée haute fréquence E1, E2, ...Ei,...Ep,...En, leurs autres extrémités étant connectées ensemble à une extrémité (B) d'une capacité de sortie (Cs) dont l'autre extrémité est connectée à la sortie haute fréquence (S) pour former autant de circuits résonnants LC série, résonnant à la fréquence de fonctionnement f, entre les entrées E1, E2, ...Ei,...Ep,...En et la sortie (S) haute fréquence, que d'amplificateurs à coupler.

2. Dispositif de couplage selon la revendication 1, **caractérisé en ce que** n étant égal à 2, la fréquence de résonance f, qui est aussi la fréquence de fonctionnement des amplificateur élémentaires, vue par une des deux entrées (E1, E2) du coupleur est :

$$f = \frac{1}{2 \cdot \pi \sqrt{L \cdot \dfrac{C}{2}}}$$

L étant la valeur identique des selfs (L1, L2) et C la valeur de la capacité de sortie (Cs).

3. Dispositif de couplage selon la revendication 2, **caractérisé en ce que** le module de l'impédance $Z_{E1,E2}$ entre les deux entrées (E1 et E2) du coupleur est donné par :

$$\left|Z_{E1,E2}\right| = (L+L).2.\pi.f = 4.L.\,\pi.f$$

4. Dispositif de couplage selon la revendication 1, **caractérisé en ce que** pour un coupleur à n entrées :

la fréquence de résonance f, vue par une des entrées (Ei) du coupleur est

$$f = \frac{1}{2\cdot\pi\sqrt{L\cdot\dfrac{C}{n}}}$$

L étant la valeur identique des selfs L1, L2, Li,...Lp,...Ln et C la valeur de la capacité de sortie du coupleur (Cs).

5. Dispositif de couplage selon la revendication 4, **caractérisé en ce que** le module de l'impédance $Z_{Ei,Ep}$ entre les deux entrées (Ei et Ep) différentes du coupleur sera donné par :

$$\left|Z_{Ei,Ep}\right| = (L+(L/n-1)).2.\pi.\,f$$

6. Dispositif de couplage selon l'une des revendications 4 ou 5, **caractérisé en ce que** l'impédance ($Z_{Ei,Ep}$) entre deux entrées sera au moins d'un facteur $K_n$ supérieur à la valeur de la charge **R** appliquée à la sortie (S) du coupleur.

7. Dispositif de couplage selon la revendication 6, **caractérisé en ce que** le facteur $K_n$ est égal à 20.

8. Dispositif de couplage selon l'une des revendications 2 ou 3, **caractérisé en ce que** dans le cas d'un coupleur à deux entrées,

$$\left|Z_{E1,E2}\right|/R > \mathbf{K_2,}$$

$K_2$ étant un facteur exprimant le rapport entre l'impédance $Z_{E1,E2}$ entre les deux entrés E1 et E2 du coupleur à deux voies et la valeur R de la charge du coupleur,
ou exprimé en fonction de L et f :

$$4.L.\,\pi.f/\,R > K_2$$

la valeur L de chacune des selfs L1, L2 sera supérieure à une valeur minimum L telle que

$$L > K_2.R/4.L.\,\pi.f$$

9. Dispositif de couplage selon revendication 8, **caractérisé en ce que** $K_2$ étant égale à 20, la valeur de L est

$$4.L.\,\pi.f/\,R > 20 \text{ , soit } L > 5.R/\pi.f$$

**10.** Dispositif de couplage selon l'une des revendications 2 ou 3, **caractérisé en ce que** la valeur C de la capacité de sortie Cs est calculée par :

$$C = \frac{1}{f^2 . 2 . \pi^2 . L}$$

**11.** Dispositif de couplage selon la revendication 1, **caractérisé en ce que** la charge (R) étant un inducteur (14) de chauffage d'une pièce (16), la valeur (Csr) de la capacité de sortie (Cs) est calculée pour obtenir l'accord avec l'inducteur (14) ainsi que l'accord de chacune des voies, d'entrées (E1, E2,...Ei,...Ep....En), à une fréquence de résonance égale à la fréquence de fonctionnement f du coupleur.

**12.** Générateur haute fréquence industrielle (HFI) comportant une pluralité de modules élémentaires (M1, M2,...Mn) état solide haute fréquence, **caractérisé en ce que** modules élémentaires sont couplés par leurs sorties de puissance (sm) par un dispositif de couplage selon l'une des revendications précédentes.

**13.** Générateur haute fréquence industrielle (HFI) état solide selon la revendication 12, **caractérisé en ce qu'**il comporte un asservissement de la fréquence f du générateur de chauffage.

**Claims**

**1.** A device for coupling high-frequency elementary amplifiers (M1, M2,...Mn) operating at a frequency f, including n high-frequency inputs E1, E2,...Ei,...Ep,...En, n being an integer greater than 1, i and p being two integers comprised between 1 and n, p being different from i, and a high frequency power output (S) for providing a load (R) with a power which is the sum of the powers provided by the whole of the elementary amplifiers connected through their power outputs (sm) to said high-frequency inputs,
**characterized in that** it includes n coils L1, L2,...Li,...Lp,...Ln, connected through one of their ends to a respective high-frequency input E1, E2,...Ei,...Ep,...En, their other ends being connected together to an end (B) of an output capacitor (Cs), the other end of which is connected to the high-frequency output (S) in order to form as many LC series resonant circuits, resonating at the operating frequency f, between the inputs E1, E2,...Ei,...Ep,...En and the high-frequency output (S), as there are amplifiers to be coupled.

**2.** The coupling device according to claim 1, **characterized in that** n being equal to 2, the resonance frequency f, which is also the operating frequency of the elementary amplifiers as seen by one of the two inputs (E1, E2) of the coupler is:

$$f = \frac{1}{2 \cdot \pi \sqrt{L \cdot \frac{C}{2}}}$$

L being the identical value of the coils (L1, L2), and C being the value of the output capacitor (Cs).

**3.** The coupling device according to claim 2, **characterized in that** the modulus of the impedance $Z_{E1,E2}$ between both inputs (E1, E2) of the coupler is given by:

$$\left| Z_{E1,E2} \right| = (L + L) \cdot 2 \cdot \pi \cdot f = 4 \cdot L \cdot \pi \cdot f$$

**4.** The coupling device according to claim 1, **characterized in that** for a coupler with n inputs:

the resonance frequency f, as seen by one of the inputs (Ei) of the coupler is

$$f = \frac{1}{2 \cdot \pi \sqrt{L \cdot \dfrac{C}{2}}}$$

L being the identical value of the coils L1, L2, Li,...Lp,...Ln, and C being the value of the output capacitance of the coupler (Cs).

5. The coupling device according to claim 4, **characterized in that** the modulus of the impedance $Z_{Ei,Ep}$ between both different inputs (Ei and Ep) of the coupler will be given by:

$$\left| Z_{Ei,Ep} \right| = (L + (L/n - 1)) \cdot 2 \cdot \pi \cdot f$$

6. The coupling device according to one of claims 4 or 5, **characterized in that** the impedance ($Z_{Ei,Ep}$) between two inputs will be greater by at least a factor $K_n$ than the value of the load R applied at the output (S) of the coupler.

7. The coupling device according to claim 6, **characterized in that** the factor $K_n$ is equal to 20.

8. The coupling device according to one of claims 2 or 3, **characterized in that** in the case of a coupler with two inputs,

$$\left| Z_{E1,E2} \right| / R > K_2$$

$K_2$ being a factor expressing the ratio between the impedance $Z_{E1,E2}$ between both inputs E1 and E2 of the two-way coupler and the value R of the load of the coupler,
or expressed as a function of L and f:

$$4 \cdot L \cdot \pi \cdot f / R > K_2$$

the value L of each of the inductors L1, L2 will be greater than a minimum value L such that

$$L > K_2 \cdot R / 4 \cdot L \cdot \pi \cdot f$$

9. The coupling device according to claim 8, **characterized in that** $K_2$ being equal to 20,
the value of L is

$$4 \cdot L \cdot \pi \cdot f > 20, \ \text{i.e.} \ L > 5 \cdot R / \pi \cdot f$$

10. The coupling device according to one of claims 2 or 3, **characterized in that** the value C of the output capacitance (Cs) is calculated with:

$$C = \frac{1}{f^2 \cdot 2 \cdot \pi^2 \cdot L}$$

11. The coupling device according to claim 1, **characterized in that** the load (R) is an inductor (14) for heating a part (16), the value (Csr) of the output capacitance (Cs) is calculated in order to obtain tuning with the inductor (14) as well as the tuning of each of input routes (E1, E2,...Ei,...Ep,...En), with a resonance frequency equal to the operating frequency f of the coupler.

**12.** A high-frequency industrial generator (HFI) including a plurality of elementary high-frequency solid-state modules (M1, M2,...Mn), **characterized in that** the elementary models are coupled by their power outputs (sm) with a coupling device according to one of the preceding claims.

**13.** The solid-state high-frequency industrial generator (HFI) according to claim 12, **characterized in that** it includes servocontrol of the frequency f of the heating generator.


**Patentansprüche**

**1.** Kopplungsvorrichtung von elementaren Hochfrequenzverstärkern (M1, M2,...Mn), die bei einer Frequenz f arbeitet, umfassend n Hochfrequenzeingänge E1, E2, ...Ei,...Ep,...En, wobei n eine ganze Zahl größer als 1 ist, i und p zwei ganze Zahlen zwischen 1 und n sind, p verschieden von i ist, und einen Hochfrequenzleistungsausgang (S), um einer Ladung (R) eine Leistung bereitzustellen, die die Summe der Leistungen ist, die von der Gesamtheit der elementaren Verstärker bereitgestellt werden, die durch ihre Leistungsausgänge (sm) mit den Hochfrequenzeingängen verbunden sind,
**dadurch gekennzeichnet dass** sie n Drosselspulen L1, L2, Li,...Lp,...Ln umfasst, die durch eines ihrer Enden mit einem entsprechenden Hochfrequenzeingang E1, E2, ...Ei,...Ep,...En verbunden sind, wobei ihre anderen Enden zusammen an ein Ende (B) einer Ausgangskapazität (Cs) verbunden sind, deren anderes Ende mit dem Hochfrequenzausgang (S) verbunden ist, um ebenso viele LC-Reihen-Resonanzschaltungen, die bei der Funktionsfrequenz f resonieren, zwischen den Eingängen E1, E2, ...Ei,...Ep,...En und dem Hochfrequenzausgang (S) wie zu koppelnde Verstärker zu bilden.

**2.** Kopplungsvorrichtung nach Anspruch 1, **dadurch gekennzeichnet, dass** n gleich zwei ist, die Resonanzfrequenz f, die auch die Betriebsfrequenz der elementaren Verstärker ist, gesehen von einem der zwei Eingänge (E1, E2) des Kopplers wie folgt ist:

$$f = \frac{1}{2 \cdot \pi \sqrt{L \cdot \frac{C}{2}}}$$

wobei L der identische Wert der Drosselspulen (L1, L2) und C der Wert der Ausgangskapazität (Cs) ist.

**3.** Kopplungsvorrichtung nach Anspruch 2, **dadurch gekennzeichnet, dass** das Modul der Impedanz $Z_{E1,\ E2}$ zwischen den zwei Eingängen (E1 und E2) des Kopplers durch Folgendes gegeben ist:

$$\left| Z_{E1,E2} \right| = (L+L).2.\pi.f = 4.L.\ \pi.f$$

**4.** Kopplungsvorrichtung nach Anspruch 1, **dadurch gekennzeichnet, dass** für einen Koppler mit n Eingängen:

die Resonanzfrequenz f, gesehen von einem der Eingänge (Ei) des Kopplers wie folgt ist:

$$f = \frac{1}{2 \cdot \pi \sqrt{L \cdot \frac{C}{n}}}$$

wobei L der identische Wert der Drosselspulen L1, L2, Li,...Lp,...Ln ist und C der Wert der Ausgangskapazität des Kopplers (Cs) ist.

**5.** Kopplungsvorrichtung nach Anspruch 4, **dadurch gekennzeichnet, dass** das Modul der Impedanz $Z_{Ei,\ Ep}$ zwischen den zwei verschiedenen Eingängen (Ei und EP) des Kopplers durch Folgendes gegeben wird:

$$\left|Z_{Ei,Ep}\right| = (L + (L/n - 1)).2.\pi.f$$

6. Kopplungsvorrichtung nach einem der Ansprüche 4 oder 5, **dadurch gekennzeichnet, dass** die Impedanz ($Z_{Ei, Ep}$) zwischen zwei Eingängen mindestens um einen Faktor $K_n$ größer ist als der Wert der Ladung R ist, die auf den Ausgang (S) des Kopplers angelegt ist.

7. Kopplungsvorrichtung nach Anspruch 6, **dadurch gekennzeichnet, dass** der Faktor $K_n$ gleich 20 ist.

8. Kopplungsvorrichtung nach einem der Ansprüche 2 oder 3, **dadurch gekennzeichnet, dass** im Fall eines Kopplers mit zwei Eingängen,

$$\left|Z_{E1,E2}\right|/R > K_2,$$

wobei $K_2$ ein Faktor ist, der das Verhältnis zwischen der Impedanz $Z_{E1, E2}$ zwischen den zwei Eingängen E1 und E2 des Zweiweg-Kopplers und dem Wert R der Ladung des Kopplers ausdrückt,
oder ausgedrückt als eine Funktion von L und f:

$$4.L.\pi.f/R > K_2$$

wobei der Wert L jeder der Drosselspulen L1, L2 größer als ein minimaler Wert L ist, so dass

$$L > K_2.R/4.L.\pi.f$$

9. Kopplungsvorrichtung nach Anspruch 8, **dadurch gekennzeichnet, dass** $K_2$ gleich 20 ist,
der Wert L wie folgt ist:

$$4.L.\pi.f/R > 20 \ , \ soit \ \ L > 5.R/\pi.f$$

10. Kopplungsvorrichtung nach einem der Ansprüche 2 oder 3, **dadurch gekennzeichnet, dass** der Wert C der Ausgangskapazität Cs berechnet wird durch:

$$C = \frac{1}{f^2.2.\pi^2.L}$$

11. Kopplungsvorrichtung nach Anspruch 1, **dadurch gekennzeichnet, dass** die Ladung (R) ein Induktor (14) zur Erwärmung eines Teils (16) ist, der Wert (Csr) der Ausgangskapazität (Cs) berechnet wird, um die Abstimmung mit dem Induktor (14) zu erhalten, ebenso wie die Abstimmung jedes der Eintrittswege (E1, E2,...Ei,...Ep....En) mit einer Resonanzfrequenz, die gleich der Betriebsfrequenz f des Kopplers ist.

12. Industrieller Hochfrequenzgenerator (HFI), umfassend eine Vielzahl von elementaren Modulen (M1, M2,...Mn) in einer Hochfrequenz-Festkörperanordnung, **dadurch gekennzeichnet, dass** die elementaren Module durch ihre Leistungsausgänge (sm) durch eine Kopplungsvorrichtung nach einem der vorhergehenden Ansprüche gekoppelt sind.

13. Industrieller Hochfrequenzgenerator (HFI) nach Anspruch 12, **dadurch gekennzeichnet, dass** er eine Servosteuerung der Frequenz f des Heizungsgenerators umfasst.

FIG.1

**FIG.2a**

**FIG.2b**

FIG.2c

**FIG.3a**

**FIG.3b**

**FIG.4a**

**FIG.4b**

**FIG.4c**

**FIG.5**

FIG.6

FIG.7a

FIG.7b

FIG.7c

FIG.8a

FIG.8b

FIG.9a

FIG.9b

FIG.10